(19) 

Europäisches
Patentamt
European
Patent Office
Office européen
des brevets

(11) **EP 4 644 924 A1**

(12) **EUROPEAN PATENT APPLICATION**

published in accordance with Art. 153(4) EPC

(43) Date of publication:
**05.11.2025 Bulletin 2025/45**

(21) Application number: **24799470.0**

(22) Date of filing: **26.09.2024**

(51) International Patent Classification (IPC):
$G01R\ 31/327^{(2006.01)}$  $\qquad$ $G01R\ 19/02^{(2006.01)}$
$G01R\ 19/165^{(2006.01)}$ $\qquad$ $G06N\ 3/08^{(2023.01)}$

(52) Cooperative Patent Classification (CPC):
**G01R 19/02; G01R 19/165; G01R 31/327;
G06N 3/08**

(86) International application number:
**PCT/KR2024/096224**

(87) International publication number:
**WO 2025/187922 (12.09.2025 Gazette 2025/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **07.03.2024 KR 20240032584**

(71) Applicant: **Hyundai Elevator Co., Ltd.
Chungju-si, Chungcheongbuk-do 27329 (KR)**

(72) Inventor: **KIM, Won Jae
Chungju-si, Chungcheongbuk-do 27329 (KR)**

(74) Representative: **Baldus, Oliver
Splanemann
Rumfordstrasse 7
80469 München (DE)**

(54) **SYSTEM AND METHOD FOR DIAGNOSING OPEN FAILURE OF SWITCH**

(57)  Disclosed is a system for diagnosing open-circuit faults in switches using an artificial neural network model. In the switch open-circuit fault diagnosis system, data input to an input layer of the artificial neural network model includes DC components and RMS values of three-phase current.

【FIG. 5】

```
        Start
          │
S110 ── Measure and store  ◄──┐
        operating data        │
          │                   │
S120 ── Process and preprocess│
        data                  │
          │                   │
S130 ── Design artificial neural
        network model         │
          │                   │
S140 ── Train artificial neural
        network model based on│
        data                  │
          │                   │
S150 ── Design algorithm      │
          │                   │
          ▼         S160      │
        Artificial            │
      neural network model ───┘ No
        sufficiently
        optimized?
          │ Yes
S170 ── Apply artificial neural
        network model
          │
        End
```

EP 4 644 924 A1

**Description**

[Technical Field]

The present invention relates to a system and method for diagnosing open-circuit faults in switches.

[Background Art]

An open-circuit fault in a switch causes distortion of current flowing through an inverter and a converter. The shape and pattern of the distortion vary depending on which switch is in an open-circuit fault condition. To diagnose open-circuit faults, it is necessary to classify various current distortion patterns associated with different faulty switches. However, manual classification of these patterns is susceptible to human error.

Korean Patent Laid-open Publication No. 10-2021-0142883 discloses an artificial intelligence-based method for diagnosing open-circuit faults in multiple switches of a three-phase PWM converter, wherein the method includes: obtaining DC components IV_dc of d-q axis current in a stationary reference frame, followed by estimating a total harmonic distortion THDv of current; grouping open-circuit fault types into multiple sectors according to the current vector angle by applying the DC components IV_dc of the d-q axis current to a pre-trained first artificial neural network (ANN); and diagnosing which switch is in an open-circuit fault condition based on the grouped sectors by applying the DC components IV_dc of the d-q axis current and the total harmonic distortion THDv of the current to a pre-trained second artificial neural network (ANN).

However, this method, which employs two artificial neural networks and uses the DC components and total harmonic distortion of current as input values, has the disadvantages of requiring high specification computers and prolonged training time.

<Prior art Reference>

<Patent document>

Korean Patent Laid-open Publication No. 10-2021-0142883

[Disclosure]

[Technical Problem]

It is an aspect of the present invention to provide a system and method for diagnosing an open-circuit fault in a switch using an artificial neural network.

[Technical Solution]

In accordance with one aspect of the present invention, there is provided a system for diagnosing an open-circuit fault in a switch using an artificial neural network model, wherein data input to an input layer of the artificial neural network model includes DC components and RMS values of three-phase current.

An open-circuit fault in the switch may be diagnosed during regenerative operation of a motor.

The number of neurons in the input layer may be 6, and the number of neurons in the output layer of the artificial neural network model may be equal to the number of switches to be diagnosed for an open-circuit fault plus one.

The DC components of the three-phase current may be calculated using the following equation:

$$i_{k\_avg}' = \sum_{n=1}^{N} i_k[n]$$

.

The RMS values of the three-phase current may be calculated using the following equation:

$$i_{k\_rms}{}' = \sum_{n=1}^{N} i_k[n]^2$$

.

In accordance with another aspect of the present invention, there is provided a method for diagnosing an open-circuit fault in a switch using an artificial neural network model, including: processing and preprocessing data to be input to an input layer of the artificial neural network model, wherein the data input to the input layer comprises DC components and RMS values of three-phase current.

The method may further include: measuring and storing operating data of a motor to generate the data to be input to the input layer, wherein the operating data may be measured during regenerative operation of the motor.

The method may further include: designing the artificial neural network model, wherein the number of neurons in the input layer may be 6, and the number of neurons in the output layer of the artificial neural network model may be equal to the number of switches to be diagnosed for an open-circuit fault plus one.

The DC components of the three-phase current may be calculated using the following equation:

$$i_{k\_avg}{}' = \sum_{n=1}^{N} i_k[n]$$

.

The RMS values of the three-phase current may be calculated using the following equation:

$$i_{k\_rms}{}' = \sum_{n=1}^{N} i_k[n]^2$$

.

[Advantageous Effects]

The present invention enables training of an artificial neural network model on relatively low specification computers while significantly reducing training time for the artificial neural network model.

The present invention can further reduce calculation by using a simplified equation to calculate DC components and RMS values.

The present invention can ensure open-circuit fault diagnosis for all switches since switch open-circuit faults are diagnosed during regenerative operation of a motor and an artificial neural network is self-trained to distinguish between unique fault current patterns associated with each faulty switch.

According to the present invention, there is an advantage in that the depth of a hidden layer (number of layers in the hidden layer) and/or the number of neurons in the hidden layer may be effectively reduced, since input values of an input layer are sufficiently characteristic to distinguish between various fault modes, which are output values of an output layer.

[Description of Drawings]

FIG. 1 is a schematic block diagram of an exemplary motor drive circuit used in elevators.
FIG. 2 illustrates fault current patterns of switches in a converter during driving of a motor.

FIG. 3 illustrates fault current patterns of switches in a converter during regenerative operation of a motor.

FIG. 4 illustrates a structure of an artificial neural network model according to one embodiment of the present invention.

FIG. 5 is a schematic flowchart of a switch open-circuit fault diagnosis method according to one embodiment of the present invention.

[Best Mode]

Hereinafter, exemplary embodiments of the present invention will be described with reference to the accompanying drawings. The present invention can be used in a wide range of applications, including switch fault diagnosis, elevator fault diagnosis, and artificial neural networks. In addition, it should be understood that the present invention is not limited to the following embodiments and may be embodied in various other ways.

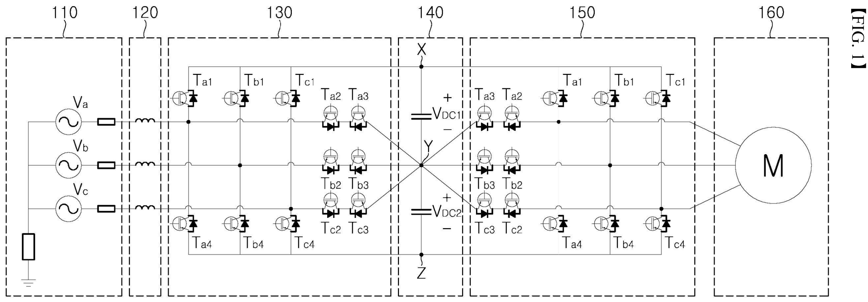

FIG. 1 is a schematic block diagram of an exemplary motor drive circuit used in elevators.

Referring to FIG. 1, the motor drive circuit for elevators may include at least one of the followings: a grid part 110, a filter part 120, a converter part 130, a connector part 140, an inverter part 150, and a motor part 160.

The grid part 110 serves to supply power to the circuit and may include an AC power source. The grid part 110 may include a three-phase AC power source.

The filter part 120 serves to allow the converter part 130 to smoothly adjust a power factor of power supplied from the grid part 110. The filter part 120 may include one or more inductors. The filter part 120 may include three inductors each connected in series to a corresponding one of the three phases of the three-phase AC power source.

The converter part 130 serves to adjust active and reactive power components of power delivered from the filter part 120. The converter part 130 may include multiple switches. The switches may be power semiconductor switches, and may be insulated gate bipolar transistors (IGBTs).

The converter part 130 may include multiple switches. A converter according to this embodiment is a 3-level PWM converter and may include 12 switches Ta1, Ta2, Ta3, Ta4, Tb1, Tb2, Tb3, Tb4, Tc1, Tc2, Tc3, Tc4.

Ta1 and Ta4 are connected in series to each other, wherein a point between the two switches may be defined as a pole. Tb1 and Tb4, Tc1 and Tc4 may be connected in same way of Ta1 and Ta4. These series-connected pairs (Ta1, Ta4), (Tb1, Tb4), and (Tc1, Tc4) may be connected in parallel to each other. Ta2 and Ta3 are connected in series to each other, and connected between the pole between Ta1 and Ta4 and point Y of the connector part. Tb2 and Tb3, Tc2 and Tc3 may be connected in same way of Ta2 and Ta3.

When the grid part 110 supplies three-phase AC power, the pole between Ta1 and Ta4 may be connected to a first phase Va, the pole between Tb1 and Tb4 may be connected to a second phase Vb, and the pole between Tc1 and Tc4 may be connected to a third phase Vc.

Each of Ta1, Tb1, and Tc1 may be connected in parallel to a first node X of the connector part 140. Each of (Ta2+Ta3), (Tb2+Tb3), and (Tc2+Tc3) may be connected in parallel to a second node Y of the connector part 140. Each of Ta4, Tb4, and Tc4 may be connected in parallel to a third node Z of the connector part 140.

This switch arrangement can reduce voltage and current harmonics while enhancing overall efficiency.

The converter part 130 can ensure operation at unity power factor (high efficiency operation) through regulation of power delivered to the connector part 140.

The connector part 140 serves to connect the converter part 130 to the inverter part 150. The connector part 140 enables conversion of DC(Direct Current) to AC(Alternating Current) or AC to DC. The connector part 140 may include multiple (for example, two) capacitors (DC-links) connected in series or in parallel. Thus, three-phase AC power supplied from the grid part 110 and having passed through the filter part 120 and the converter part 130 may be stored as DC power in the connector part 140.

The first node X connected in parallel to each of Ta1, Tb1, and Tc1 of the converter part 130 may be connected to a positive terminal of a first capacitor $V_{DC1}$. The second node Y connected in parallel to each of (Ta2+Ta3), (Tb2+Tb3), and (Tc2+Tc3) of the converter part 130 may be connected to a negative terminal of the first capacitor $V_{DC1}$ and a positive terminal of a second capacitor $V_{DC2}$. The third node Z connected in parallel to each of Ta4, Tb4, and Tc4 of the converter part 130 may be connected to a negative terminal of the second capacitor $V_{DC2}$.

The inverter part 150 serves to convert current from the connector part 140 into a suitable form to drive a motor M. The inverter part 150 may convert DC from the connector part 140 to AC required for driving the motor M by changing the frequency and magnitude of the DC.

The inverter part 150 may include multiple switches. The switches may be power semiconductor switches, and may be insulated gate bipolar transistors (IGBTs).

For example, the inverter part 150 may include 12 switches Ta1, Ta2, Ta3, Ta4, Tb1, Tb2, Tb3, Tb4, Tc1, Tc2, Tc3, Tc4.

Ta1 and Ta4 are connected in series to each other, wherein a point between the two switches may be defined as a pole. Tb1 and Tb4, Tc1 and Tc4 may be connected in same way of Ta1 and Ta4. These series-connected pairs (Ta1, Ta4),

**EP 4 644 924 A1**

(Tb1, Tb4), and (Tc1, Tc4) may be connected in parallel to each other. Ta2 and Ta3 are connected in series to each other, and connected between the pole between Ta1 and Ta4 and point Y of the connector part. Tb2 and Tb3, Tc2 and Tc3 may be connected in same way of Ta2 and Ta3.

Each of Ta1, Tb1, and Tc1 may be connected in parallel to the first node X of the connector part 140. Each of (Ta3+Ta2), (Tb3+Tb2), and (Tc3+Tc2) may be connected in parallel to the second node Y of the connector part 140. Each of Ta4, Tb4, and Tc4 may be connected in parallel to the third node Z of the connector part 140.

This switch arrangement can reduce voltage and current harmonics while enhancing overall efficiency.

The motor part 160 includes a motor M. The motor M may be driven by current from the inverter part 150 that has been converted to be suitable for driving the motor M.

An open-circuit fault in a switch restricts the flow of current through the faulty switch, causing distortion of current flowing through the circuit. As a result, high efficiency operation cannot be achieved since the converter part 130 fails to achieve unity power factor, while the motor M of the motor part 160 cannot be properly controlled.

When an open-circuit fault occurs in a switch in the inverter part 150, vibration and noise can occur in the motor M. Accordingly, it is possible to externally detect that one or more of the switches in the inverter part 150 are in an open-circuit fault condition.

Conversely, when an open-circuit fault occurs in a switch in the converter part 130, it is difficult to externally detect the presence of the fault, leading to a situation in which the circuit continues to operate under faulty conditions. This can result in reduced operating efficiency and can lead to secondary failures, such as burning and short circuit due to overheating. Therefore, there is a need for a technology that can diagnose open-circuit faults in switches in the converter part 130 that are difficult to detect by external monitoring.

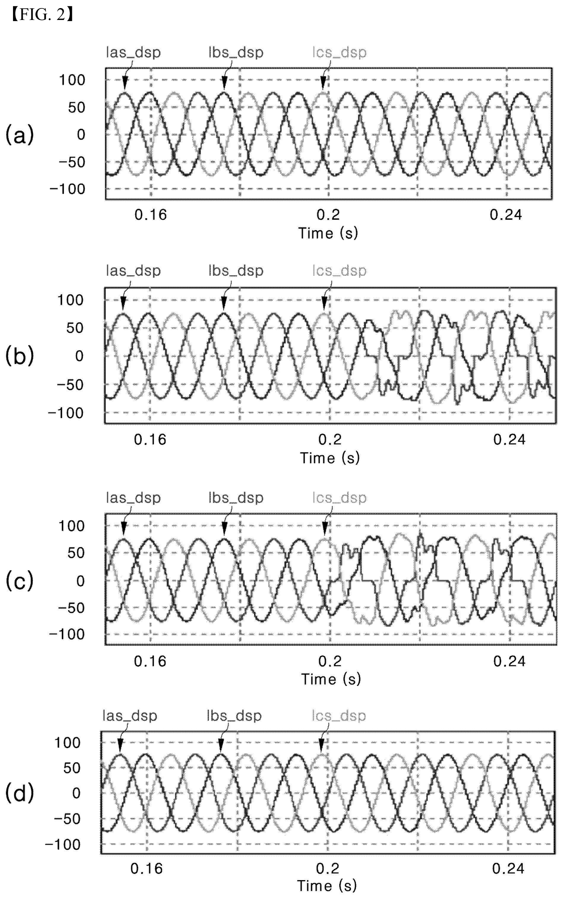

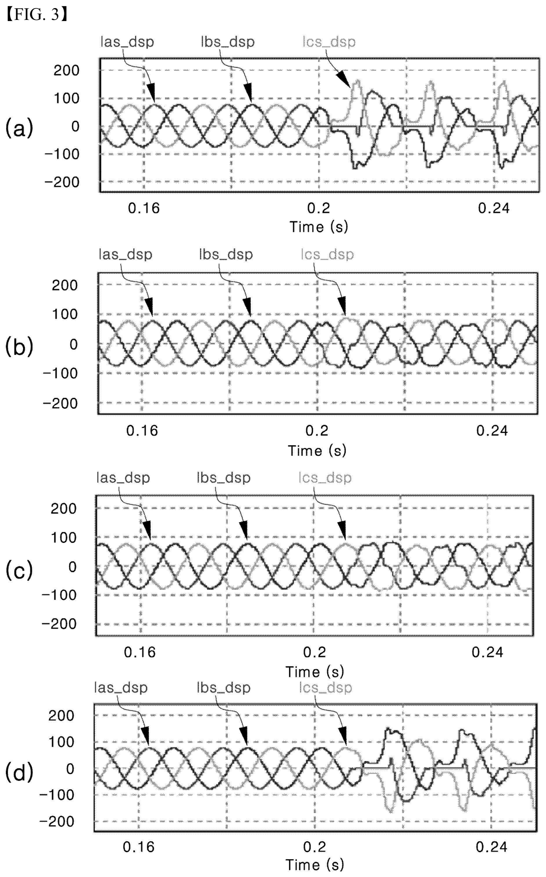

FIG. 2 illustrates fault current patterns of switches in the converter part 130 during driving of the motor M, and FIG. 3 illustrates fault current patterns of switches in the converter part 130 during regenerative operation of the motor M. In FIG. 2 and FIG. 3, (a) represents a fault current pattern of Ta1, (b) represents a fault current pattern of Ta2, (c) represents a fault current pattern of Ta3, and (d) represents a fault current pattern of Ta4.

Referring to FIG. 2, it can be seen that current distortion may occur in Ta2 and Ta3 of the converter part 130, but no current distortion may occur in Ta1 and Ta4 of the converter part 130, while the motor M is operating in driving mode.

Referring to FIG. 1, when the motor M operates in driving mode, Ta2, Ta3, Tb2, Tb3, Tc2, and Tc3 of the converter part 130 are operated using both power semiconductors and diodes , whereas Ta1, Tb1, Tc1, Ta4, Tb4, and Tc4 of the converter part 130 are operated only using diodes, so that even if an open-circuit fault occurs in Ta1, Tb1, Tc1, Ta4, Tb4, or Tc4 of the converter part 130, normal operation may be possible and no current distortion may occur. Accordingly, by driving of the motor M, only open-circuit faults in Ta2, Ta3, Tb2, Tb3, Tc2, and Tc3 of the converter part 130 can be diagnosed, and open-circuit faults in Ta1, Tb1, Tc1, Ta4, Tb4, and Tc4 of the converter part 130 cannot be diagnosed.

Conversely, referring to FIG. 3, it can be seen that current distortion may occur in all of Ta1, Ta2, Ta3, and Ta4 of the converter part 130, while the motor M is in regenerative operation mode.

Referring to FIG. 1, when the motor M operates in regenerative operation mode, all switches Ta1, Tb1, Tc1, Ta2, Tb2, Tc2, Ta3, Tb3, Tc3, Ta4, Tb4, Tc4 of the converter part 130 are operated using both power semiconductors and diodes, so that current distortion may occur when an open-circuit fault occurs in all of the switches. Accordingly, open-circuit faults of the switches may be diagnosed during regenerative operation of the motor M, in order to diagnose open-circuit faults in all the switches through current distortion.

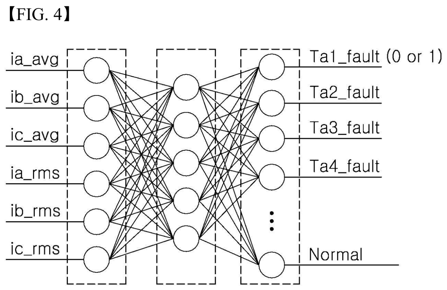

FIG. 4 illustrates a structure of an artificial neural network model according to one embodiment of the present invention.

Referring to FIG. 1 and FIG. 4, the artificial neural network model according to the present invention may include an input layer I, a hidden layer H, and an output layer O.

The input layer I receives input of data used to train the artificial neural network model and may include one or more neurons. For example, when three-phase current is supplied from the grid part 110, the input layer I may include six neurons, corresponding to three DC components of the three-phase current plus three RMS(Root Mean Square) values of the three-phase current.

5

EP 4 644 924 A1

The hidden layer H processes the data input to the input layer I to generate output data and may include one or more neurons. The optimal number of neurons in the hidden layer H may be determined through iterative training, considering factors such as calculation time and accuracy.

The output layer O outputs the output data generated by the hidden layer H and may include one or more neurons. When switches in the converter part 130 are a target of diagnosis, the number of neurons in the output layer O may be equal to the number of switches in the converter part 130 plus one (respective fault modes of the switches plus a mode in which the switches are all operating normally).

Since the current distortion pattern varies depending on which switch has failed, the number of fault modes corresponds to the number of switches. When the converter part 130 includes 12 switches, fault modes in the converter part 130 may be 12. Accordingly, the output layer O will have 13 neurons. Determination of the number of neurons in each of the input layer I, the output layer O, and the hidden layer H will be described in detail further below.

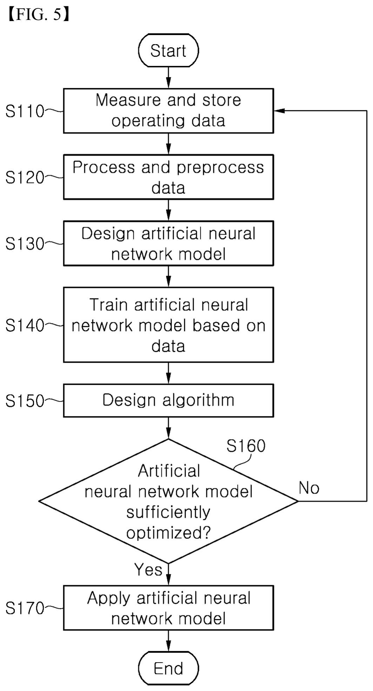

FIG. 5 is a schematic flowchart of a switch open-circuit fault diagnosis method according to one embodiment of the present invention.

Referring to FIG. 5, the switch open-circuit fault diagnosis method according to the present invention may include one or more of the following steps: measuring and storing operating data S110; processing and preprocessing the data S120; designing an artificial neural network model S130; training the artificial neural network model based on the data S140; designing an algorithm for the artificial neural network model S150; determining whether the artificial neural network model is sufficiently optimized S160; and diagnosing open-circuit faults in switches using the artificial neural network model S170.

### 1) Step of measuring and storing operating data S110

To generate data to be input to the input layer I of the artificial neural network, operating data of a system employing a motor M and switches (for example, an elevator) may be measured and stored. The operating data may include values of three-phase AC supplied by a three-phase AC power supply of a grid part 110.

### 2) Step of processing and preprocessing data S120

The stored operating data may be processed and preprocessed to be suitable for input to the input layer I of the artificial neural network. The step of processing and preprocessing the data may include calculating DC components and RMS values of the three-phase AC.

The DC components of the three-phase current may be calculated using the following equation:

$$i_{k\_avg} = \frac{\sum_{n=1}^{N} i_k[n]}{N}$$ .

When switch open-circuit fault is diagnosed using an artificial neural network model, large and small relationship of values obtained from an equation depending on the fault condition may be more significant than the magnitude of the values themselves. Given that omission of division does not affect the large and small relation between the values, and division may be a big burden on the computer, calculation of the DC components of the three-phase current may be simplified by omitting division from the above equation as follows:

$$i_{k\_avg}' = \sum_{n=1}^{N} i_k[n]$$ .

According to the present invention, there is an advantage in that calculation burden on the computer may be reduced, thereby enabling training of the artificial neural network model on relatively low specification computers and reducing training time, by employing an equation excluding division in order to calculate the DC components of the three-phase current.

6

The RMS values of the three-phase current may be calculated using the following equation:

$$i_{k\_rms} = \sqrt{\frac{\sum_{n=1}^{N} i_k[n]^2}{N}}$$

Similarly, given that omission of division and square root operations does not affect the large and small relation between the values, and division and square root operations may be a big burden on the computer, calculation of the RMS values of the three-phase current may be simplified by omitting division and square root operations from the above equation as follows:

$$i_{k\_rms}' = \sum_{n=1}^{N} i_k[n]^2$$

.

According to the present invention, there is an advantage in that calculation burden on the computer may be reduced, thereby enabling training of the artificial neural network model on relatively high specification computers and reducing training time, by employing an equation excluding division and square root operations in order to calculate the RMS values of the three-phase current.

## 3) Step of designing artificial neural network model S130

The artificial neural network model may be designed by determining the type and number of neurons in the input layer I and the type and number of neurons in the output layer O.

The number of neurons in the input layer I may be determined by the number of inputs used for diagnosis, and the number of neurons in the output layer O may be determined by the number of faults to be diagnosed.

When three-phase current is supplied from the grid part 110, the input layer I may include 6 neurons, corresponding to three DC components and three RMS values of the three-phase current. When switches in the converter part 130 are a target of diagnosis, the number of neurons in the output layer O may be equal to the number of switches in the converter part 130 plus one (respective fault modes of the switches plus a mode in which the switches are all operaing normally).

## 4) Step of training artificial neural network model based on data S140

The artificial neural network model may be trained based on the data input to the input layer I to generate output data.

Here, "training" may refer to a process of finding weight parameters W that exist between layers. The weight parameters W serve as synapses between layers to determine the rate of transfer of output values from an activation function. The weight parameters W may be optimized in a way that minimizes discrepancy between predictions of the artificial neural network model and true values.

To optimize the weight parameters W, a back-propagation algorithm may be used. The discrepancy may be calculated using a cross-entropy error function.

The numbers of layers and neurons in the hidden layer H may be initially set to approximate values(may be based on experience). Subsequently, weight parameters may be found through training and diagnostic performance (discrepancy, cross-entropy error) may be confirmed, and then if the diagnostic performance is degraded, diagnostic performance may be improved by increasing the number of neurons in the hidden layer H. Conversely, if the diagnostic performance is satisfactory when trained with the initial numbers of layers and neurons in the hidden layer H, calculation burden may be reduced by reducing the numbers of layers and neurons in the hidden layer H while maintaining performance. Though this iterative training process, it is possible to determine the optimal numbers of layers and neurons in the hidden layer H and the optimal weight parameters that can provide satisfactory results in terms of both diagnostic performance and calculation load. That is, the optimal number of neurons in the hidden layer can be determined through the iterative training process.

According to the present invention, there is an advantage in that a depth of the hidden layer H (number of layers in the hidden layer H) and/or the number of neurons in the hidden layer H may be effectively reduced, since input values (DC components, RMS values) of an input layer I are sufficiently characteristic to distinguish between various fault modes (respective fault modes of switches plus a mode in which the switches are all operaing normally), which are output values of an output layer O. In the present invention, a depth of the hidden layer H may be 1 layer and number of neurons in the hidden layer H may be 5, which offers a significantly simple configuration compared to that of typical artificial neural networks.

**5) Step of designing algorithm for artificial neural network model S150**

An algorithm for diagnosis of switch open-circuit faults may be designed using the artificial neural network model. For example, C programming language code may be used to design the algorithm.

**6) Step of determining whether artificial neural network model is sufficiently optimized S160 and step of diagnosing open-circuit fault in switch using artificial neural network model S170**

A determination may be made as to whether the artificial neural network model is sufficiently optimized for diagnosing switch open-circuit faults. If it is determined that the artificial neural network model is sufficiently optimized (if Yes is selected in S160), diagnosis of switch open-circuit faults may be conducted by applying the artificial neural network model. If it is determined that the artificial neural network model is not sufficiently optimized (if No is selected in S160), steps 1 to 5 may be repeated to further optimize the artificial neural network model.

Computer specifications and training time for the artificial neural network model may vary greatly depending on the type of data input to the input layer I, the number of neurons in the input layer I, the type of data output from the output layer O, and the number of neurons in the output layer O. For practical use of the artificial neural network model, realistic computer specifications and training time are required. If more efficient and accurate output data can be obtained using only lower specification computers and less training time, artificial neural network model can be evaluated as better designed.

According to the present invention, when three-phase AC power is supplied from the grid part 110, the number of neurons in each of the input layer I and the hidden layer H of the artificial neural network model and the number of layers in the hidden layer H can be significantly reduced by using DC components and RMS values as input data for the artificial neural network model. Reduction in the number of layers in the hidden layers H and the numbers of neurons in each of the input layer I and the hidden layer H enables training of the artificial neural network model on relatively low specification computers and reducing training time.

According to the present invention, calculation can be further reduced by using a simplified equation to calculate DC components and RMS values.

According to the present invention, open-circuit fault of all switches can be diagnosed, since switch open-circuit faults are diagnosed during regenerative operation of the motor M, rather than during driving of the motor M, and the artificial neural network is self-trained to distinguish between current patterns according to faulty switch.

Although some embodiments have been described herein, it should be understood that the foregoing embodiments are provided for illustration only and are not to be in any way construed as limiting the present invention, and that various modifications, variations, and alterations can be made by those skilled in the art without departing from the spirit and scope of the present invention.

<List of reference numerals>

| 110: | Grid part | 120: | Filter part |
|------|-----------|------|-------------|
| 130: | Converter part | 140: | Connector part |
| 150: | Inverter part | 160: | Motor part |
| I: | Input layer | H: | Hidden layer |
| O: | Output layer | | |

**Claims**

1. A system for diagnosing an open-circuit fault in a switch using an artificial neural network model, wherein data input to an input layer of the artificial neural network model comprises DC components and RMS values of three-phase current.

2. The system according to claim 1, wherein an open-circuit fault in the switch is diagnosed during regenerative operation of a motor.

3. The system according to claim 1 or 2, wherein the number of neurons in the input layer is 6, and the number of neurons in the output layer of the artificial neural network model is equal to the number of switches to be diagnosed for an open-circuit fault plus one.

4. The system according to claim 1 or 2, wherein the DC components of the three-phase current are calculated using the following equation:

$$i_{k\_avg}' = \sum_{n=1}^{N} i_k[n]$$
.

5. The system according to claim 1 or 2, wherein the RMS values of the three-phase current are calculated using the following equation:

$$i_{k\_rms}' = \sum_{n=1}^{N} i_k[n]^2$$
.

6. A method for diagnosing an open-circuit fault in a switch using an artificial neural network model, comprising:

    processing and preprocessing data to be input to an input layer of the artificial neural network model,
    wherein the data input to the input layer comprises DC components and RMS values of three-phase current.

7. The method according to claim 6, further comprising:

    measuring and storing operating data of a motor to generate the data to be input to the input layer,
    wherein the operating data is measured during regenerative operation of the motor.

8. The method according to claim 6 or 7, further comprising:

    designing the artificial neural network model,
    wherein the number of neurons in the input layer is 6, and the number of neurons in the output layer of the artificial neural network model is equal to the number of switches to be diagnosed for an open-circuit fault plus one.

9. The method according to claim 6 or 7, wherein the DC components of the three-phase current are calculated using the following equation:

$$i_{k\_avg}' = \sum_{n=1}^{N} i_k[n]$$

.

10. The method according to claim 6 or 7, wherein the RMS values of the three-phase current are calculated using the following equation:

$$i_{k\_rms}' = \sum_{n=1}^{N} i_k[n]^2$$

.

【FIG. 1】

【FIG. 2】

【FIG. 3】

(a)

(b)

(c)

(d)

【FIG. 4】

【FIG. 5】

## INTERNATIONAL SEARCH REPORT

| International application No. |
|---|
| **PCT/KR2024/096224** |

| A. | CLASSIFICATION OF SUBJECT MATTER |
|---|---|

**G01R 31/327**(2006.01)i; **G01R 19/02**(2006.01)i; **G01R 19/165**(2006.01)i; **G06N 3/08**(2006.01)i

According to International Patent Classification (IPC) or to both national classification and IPC

| B. | FIELDS SEARCHED |
|---|---|

Minimum documentation searched (classification system followed by classification symbols)

G01R 31/327(2006.01); G01R 19/165(2006.01); G01R 31/02(2006.01); G01R 31/28(2006.01); G01R 31/40(2006.01); G01R 31/54(2020.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 인공 신경망(artificial neural network), 스위치(switch), 개방고장(open fault), 진단 (diagnosis), 전류(current)

| C. | DOCUMENTS CONSIDERED TO BE RELEVANT |
|---|---|

| Category* | Citation of document, with indication, where appropriate, of the relevant passages | Relevant to claim No. |
|---|---|---|
| DY | KR 10-2021-0142883 A (KNU-INDUSTRY COOPERATION FOUNDATION) 26 November 2021 (2021-11-26) <br> See paragraph [0086]; claims 1 and 10; and figure 5. | 1,3-6,8-10 |
| DA | | 2,7 |
| Y | KR 10-2012-0113908 A (PUSAN NATIONAL UNIVERSITY INDUSTRY-UNIVERSITY COOPERATION FOUNDATION) 16 October 2012 (2012-10-16) <br> See paragraph [0029]; and figure 7. | 1,3-6,8-10 |
| Y | 김원재 등. ANN에 기반한 3상 PWM 컨버터의 다중 스위치 개방고장 진단 방법. 전기학회논문지. vol. 70, no. 5, May 2021, <br> pp. 764-775 (KIM, Won-Jae et al. ANN-Based Diagnostic Method on Multiple Open-Switch Fault for Three-Phase PWM Converters. The Transactions of the Korean Institute of Electrical Engineers). [Retrieved on 12 November 2024]. Retrieved from <https://www.dbpia.co.kr/journal/articleDetail?nodeId=NODE10553670&language=ko_KR&hasTopBanner=true>. <br> See page 767; and figure 5. | 3,8 |

| ✓ Further documents are listed in the continuation of Box C. | ✓ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 December 2024** | **26 December 2024** |

| Name and mailing address of the ISA/KR | Authorized officer |
|---|---|
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2024/096224** |

### C.    DOCUMENTS CONSIDERED TO BE RELEVANT

| Category* | Citation of document, with indication, where appropriate, of the relevant passages | Relevant to claim No. |
| --- | --- | --- |
| A | KR 10-2018-0053137 A (FOUNDATION FOR RESEARCH AND BUSINESS, SEOUL NATIONAL UNIVERSITY OF SCIENCE AND TECHNOLOGY) 21 May 2018 (2018-05-21)<br>See paragraphs [0056]-[0057]; and figure 3. | 1-10 |
| A | US 2022-0146592 A1 (WUHAN UNIVERSITY) 12 May 2022 (2022-05-12)<br>See paragraphs [0050]-[0077]; and figure 1. | 1-10 |

Form PCT/ISA/210 (second sheet) (July 2022)

**INTERNATIONAL SEARCH REPORT**
**Information on patent family members**

International application No.

**PCT/KR2024/096224**

| Patent document cited in search report | | | Publication date (day/month/year) | Patent family member(s) | | | Publication date (day/month/year) |
|---|---|---|---|---|---|---|---|
| KR | 10-2021-0142883 | A | 26 November 2021 | KR | 10-2415535 | B1 | 01 July 2022 |
| KR | 10-2012-0113908 | A | 16 October 2012 | KR | 10-1235182 | B1 | 21 February 2013 |
| KR | 10-2018-0053137 | A | 21 May 2018 | KR | 10-1893174 | B1 | 29 August 2018 |
| US | 2022-0146592 | A1 | 12 May 2022 | CN | 112444759 | A | 05 March 2021 |
| | | | | CN | 112444759 | B | 14 September 2021 |
| | | | | US | 11874336 | B2 | 16 January 2024 |

Form PCT/ISA/210 (patent family annex) (July 2022)

## REFERENCES CITED IN THE DESCRIPTION

**Patent documents cited in the description**

- KR 1020210142883